# FASCICULE DE BREVET EUROPEEN

(11) **EP 2 693 468 B1**
(45) Date de publication et mention de la délivrance du brevet: **08.08.2018**
(21) Numéro de dépôt: 13178410.0
(22) Date de dépôt: 29.07.2013
(51) Int. Cl.: H01L 21/60, H01L 23/485

(54) **Procédé d'assemblage de deux composants électroniques entre eux, de type flip-chip**
Verfahren vom Typ Flip-Chip zum Zusammenbauen zweier elektronischer Bauteile
Flip-chip method for assembling two electronic components

(30) Priorité: 31.07.2012 FR 1257406
(43) Date de publication de la demande: 05.02.2014
(73) Titulaire: COMMISSARIAT À L'ÉNERGIE ATOMIQUE ET AUX ÉNERGIES ALTERNATIVES, 75015 Paris (FR)
(72) Inventeur: Goubault de Brugiere, Baptiste, 38500 La Buisse (FR); Bedoin, Alexis, 38600 Fontaine (FR)
(74) Mandataire: Nony

(56) Documents cités:
- US-A- 5 667 132
- US-A1- 2005 104 222
- US-A1- 2011 304 058
- US-A1- 2012 120 622
- SAINT-PATRICE D ET AL: "New reflow soldering and tip in buried box (TB2) techniques for ultrafine pitch megapixels imaging array", 58TH ELECTRONIC COMPONENTS AND TECHNOLOGY CONFERENCE - 27-30 MAY 2008 - LAKE BUENA VISTA, FL, USA, IEEE, PISCATAWAY, NJ, USA, 27 mai 2008 (2008-05-27), pages 46-53, XP031276169, ISBN: 978-1-4244-2230-2
- GOUBAULT DE BRUGIERE B ET AL: "A 10 m pitch interconnection technology using micro tube insertion into Al-Cu for 3D applications", ELECTRONIC COMPONENTS AND TECHNOLOGY CONFERENCE (ECTC), 2011 IEEE 61ST, IEEE, 31 mai 2011 (2011-05-31), pages 1400-1406, XP031996720, DOI: 10.1109/ECTC.2011.5898695 ISBN: 978-1-61284-497-8

## Description

### Domaine technique

La présente invention concerne un procédé d'assemblage de deux composants électroniques entre eux, du type à connexions verticales, plus communément appelé procédé « flip-chip » en anglais ou « puce retournée », selon lequel l'un des deux composants électroniques est retourné pour pouvoir effectuer les connexions électriques ou assemblages à la verticale.

L'invention permet d'obtenir un assemblage entre composants électroniques quel que soit leur pas d'interconnexion et l'espacement entre ces composants.

L'invention concerne plus particulièrement l'assemblage entre une puce et un substrat, par exemple tous deux réalisés en silicium.

L'invention vise à contrôler l'espacement final entre composants électroniques une fois l'assemblage réalisé.

Par « assemblage de deux composants électroniques », on entend dans le cadre de l'invention aussi bien un assemblage de deux composants de matériaux différents qu'un assemblage de deux composants réalisés dans le même matériau. En particulier, un assemblage selon l'invention peut concerner un assemblage entre une puce électronique et un substrat, tous deux pouvant être réalisés en silicium.

Par « pas d'interconnexion », on entend la distance entre deux plots de connexion sur un même composant électronique.

Par « espacement entre composants », on entend l'écartement entre les deux composants en regard défini par la hauteur d'interconnexion.

### Etat de la technique

La technique dite de « Flip-Chip » est une technique bien connue pour réaliser l'interconnexion mécanique et électrique, ou assemblage entre deux composants, tel qu'entre une puce et un substrat de circuit imprimé. Cette technique est dite « Flip-Chip » car l'un des composants, en général la puce, qui porte des conducteurs, est retourné pour mettre en face-à-face les deux composants pour permettre les opérations d'interconnexions par solidarisation entre les conducteurs et des protubérances métalliques, connues sous l'appellation en anglais « bumps » et formant des contacts réalisés sur l'autre composant, en général un substrat de circuit imprimé.

Selon cette technique, on cherche constamment à réduire l'espacement entre composants tout en permettant un nombre de connexions toujours plus élevé. Or, les trois grandes catégories d'assemblage actuellement connues selon cette technique que sont le brasage, la thermocompression et l'utilisation d'adhésifs, tels que les ACF (acronyme anglais d' « *Anisotropic Conductive Films* »), montrent chacune leurs limites pour réduire l'espacement.

En particulier, la thermocompression à basse température par pénétration d'inserts conducteurs dans des protubérances, telle que décrite dans la demande WO 2006/054005, est limitée par la très grande force à appliquer pour un nombre très élevé de connexions à établir et par la faisabilité de réalisation proprement dite des inserts.

Aussi, pour remédier aux limites de cette méthode, la demanderesse a proposé dans la demande de brevet WO2009/115686, la réalisation d'inserts conducteurs sous forme de tubes borgnes dont la base est solidarisée à la surface d'un composant. Les inserts conducteurs ont fait l'objet d'une demande de brevet de perfectionnement EP2287904 avec au moins une surface de l'extrémité ouverte d'un insert laissée libre de sorte à permettre l'échappement des gaz contenus dans l'insert, lors de l'insertion. Différentes nouvelles formes sont prévues dans cette demande pour les inserts conducteurs, telles que barre ouverte, éléments à section transversale en étoile, en croix, avec lobes... Bien que donnant largement satisfaction en termes de niveau de forces à appliquer ainsi qu'en faisabilité de réalisation des inserts, la méthode selon ces demandes de brevet peut être encore améliorée.

Plus particulièrement, les inventeurs de la présente demande ont cherché une solution pour maîtriser avec certitude et très précisément l'espacement entre deux composants à hybrider selon une méthode de thermocompression à basse température et pour éviter tout risque de court-circuit électrique entre les inserts conducteurs d'un composant et les plots de connexion de l'autre composant.

Il est déjà connu dans la technique « Flip-Chip » d'utiliser différents types de cales, c'est-à-dire d'entretoises qui permettent de maintenir un écartement constant entre composants.

Les demandes de brevets FR2694841, US2003/0038157 et WO9306964 mettent en oeuvre une méthode de brasage et divulguent l'utilisation de cales dont le matériau constitutif a une température de fusion plus élevée que les protubérances d'interconnexion afin de rester solides lors de la fusion, communément désignée sous le terme de refonte, desdits plots d'interconnexion.

La demande de brevet US2005/0104222 propose d'utiliser des cales en forme de cordons non-continus qui sont refondus en même temps que les protubérances d'interconnexions. Les cales sont ici réalisées pour compenser les contraintes dues aux dilatations thermiques durant le fonctionnement.

La demande de brevet JP3030349 propose de réaliser des cales sous forme de gouttes de colle, telle que de la silicone, injectée par seringue, qui permettent d'absorber une partie des contraintes lors de la refonte des protubérances d'interconnexion tout en garantissant l'espacement entre puces.

La demande de brevet WO2011/018572 propose d'utiliser des cales sous forme de billes aux extrémités des composants, un insert solidarisé à l'un des composants étant inséré dans chaque bille. Les cales ont une hauteur qui doit être supérieure à un cordon d'herméticité agencé intérieurement aux cales pour réaliser l'étanchéité des clous de support de bolomètre. Les cales formées par les billes sont déformées plastiquement lors de l'assemblage des composants.

La demande de brevet FR2928032 propose d'utiliser des cales au niveau de chaque piste enterrée d'interconnexion dans laquelle une pointe est insérée. Ces cales en matériau conducteur et ductile supportent les pointes et ont une hauteur permettant de contrôler localement la pénétration de la pointe dans la piste enterrée et permettent d'éviter l'utilisation d'une colle.

La demande de brevet US2010/079631 concerne un procédé de fabrication d'un dispositif d'imagerie et propose un assemblage entre composants par l'insertion de broches dans un matériau déformé plastiquement. Des cales sont placées entre chaque plot de contact en matériau ductile sur chacun des composants afin d'empêcher que les broches traversent entièrement les plots ductiles. Un inconvénient important est que les cales des composants qui doivent être en appui mutuellement doivent être parfaitement alignées les unes sur les autres. De plus, il y a ici des cales sur les deux faces des composants, réalisées dans un matériau différent des interconnexions en elles-mêmes: elles doivent donc être parfaitement alignées pour être utiles. Placées de façon systématique entre les connexions, elles limitent la distance minimale entre deux connexions, c'est-à-dire qu'elles limitent le pas. La publication scientifique "New Reflow Soldering and Tip in Buried Box (TB2) Techniques For Ultrafine Pitch Megapixels Imaging Array" (2008 electronic Components and Technology Conférence) concerne un procédé d'interconnexion par insertion d'inserts conducteurs dans des protubérances. Plus particulièrement, ledit document a l'objectif d'évaluer la force d'insertion minimale à appliquer lors du procédé. Le but général de l'invention est de proposer une amélioration de méthode d'assemblage selon les demandes de brevet WO2009/115686 et EP2287904 précitées et qui pallie au moins une partie des inconvénients de l'état de l'art mentionné ci-avant.

Un but particulier de l'invention est de proposer une solution pour maîtriser avec certitude et très précisément l'espacement entre deux composants microélectroniques à assembler selon une méthode de thermocompression à basse température et pour éviter tout risque de court-circuit électrique entre les inserts conducteurs d'un composant et les plots de connexion de l'autre composant.

### Exposé de l'invention

Pour ce faire, l'invention a tout d'abord pour objet selon une première alternative, un procédé d'assemblage de type flip-chip, entre deux composants micro électroniques l'un à l'autre, lesdits composants comportant chacun une face, dite face d'assemblage, selon lequel on rapproche les deux faces d'assemblage l'une de l'autre et on applique d'une force constante donnée F à l'un et/ou l'autre des composants, l'un et/ou l'autre face(s) d'assemblage comportant:
- des inserts de connexion en matériau rigide ;
- des protubérances d'interconnexion en matériau ductile présentant une limite élastique σₑ donnée; les protubérances d'interconnexion d'un composant présentant une surface S1 de contact avec l'autre composant une fois les deux composants assemblés;
- des protubérances d'espacement, dites cales, les cales d'un composant présentant une surface S2 de contact avec l'autre composant une fois les deux composants assemblés,
   procédé selon lequel préalablement à l'application de la force F:
- on aligne les inserts en regard des protubérances d'interconnexion ;
- on détermine d'une part la hauteur H des cales de sorte à ce qu'elle soit supérieure à celle h des inserts de connexion une fois les deux composants assemblés et d'autre part, la surface S2 des cales de sorte que lorsqu'elles sont en contact avec l'autre composant la contrainte σ engendrée dans les protubérances d'interconnexion, générée par la force F, égale à F/(S1+S2) soit inférieure ou égale à leur limite élastique σ_{e;}
puis on applique la force constante donnée F pour faire pénétrer les inserts dans les protubérances d'interconnexion jusqu'à obtenir le contact d'assemblage entre les cales d'un composant avec l'autre composant définissant les surfaces de contact S1 et S2.

De préférence, pour rendre plus simple la réalisation, les protubérances d'interconnexion et les cales sont réalisées dans le même matériau, et de préférence lors des mêmes étapes de fabrication. On peut également envisager à titre de variante de réaliser des protubérances d'interconnexion et des cales dans différents matériaux. Selon cette variante, il est alors avantageux de prendre un matériau plus dur pour les cales que pour celui des protubérances d'interconnexion. A titre d'exemple, on peut envisager des cales en or ou en tungstène tandis que les protubérances d'interconnexion sont en indium.

Cette première alternative est avantageusement mise en oeuvre lorsque le pas d'interconnexion entre deux plots de connexion est très faible, de préférence lorsqu'il est inférieur ou égal à 50 µm.

Les cales sont de préférence de forme parallépipédique ou cylindrique. L'agencement des cales peut être périphérique ou non. On peut prévoir un agencement périphérique avec des cales sous la forme d'un cordon continu ou une couronne discontinue. On peut également prévoir un agencement non périphérique des cales par répartition en groupes au sein des protubérances de connexion.

Grâce à l'invention, on peut maîtriser très finement l'espacement entre les deux composants lors de leur assemblage et ceci sans ajouter d'étape supplémentaire à leur fabrication ni au process d'assemblage. Ainsi, selon cette première alternative de l'invention, on réalise un assemblage de deux composants, notamment entre deux puces microélectroniques, par l'utilisation de cales dont le matériau est de préférence identique à celui des protubérances d'interconnexion. Les cales selon l'invention sont dimensionnées de manière à augmenter brutalement la surface de contact entre les deux composants, lorsque l'insertion des inserts dans les protubérances est de préférence totale, et ainsi réduire significativement la contrainte engendrée dans les protubérances d'interconnexion. Cette diminution de contrainte permet de passer du régime plastique au régime élastique dans les protubérances d'interconnexion de manière à arrêter leur déformation plastique irréversible. En effet, pour parvenir à insérer les inserts dans les protubérances d'interconnexion, ces dernières doivent être déformées plastiquement. La force appliquée sur les composants doit donc permettre de dépasser la contrainte de limite élastique du matériau constituant les protubérances d'interconnexion. Cette force d'insertion est donc calculée en fonction des propriétés du matériau constitutif des protubérances. Selon l'invention, lorsque les inserts sont insérés de préférence totalement dans les protubérances et que les composants entrent en contact au niveau des cales, la surface de contact augmente brutalement et fait chuter la contrainte dans les protubérances d'interconnexion en dessous de leur contrainte de limite élastique. Ainsi, quel que soit le temps de maintien de la force appliquée, l'espacement entre composants assemblés ne varie plus. Le principal avantage de l'invention est de supprimer définitivement tout problème de court-circuit.

Selon une deuxième alternative, l'invention a pour objet un procédé d'assemblage de type flip-chip, entre deux composants microélectroniques l'un à l'autre, lesdits composants comportant une de leurs faces, dite face d'assemblage, selon lequel on rapproche les deux faces d'assemblage l'une de l'autre et on applique d'une force constante donnée F à l'un et/ou l'autre des composants, l'un et/ou l'autre face(s) d'assemblage comportant:
- des inserts de connexion en matériau rigide;
- des protubérances d'interconnexion en matériau ductile présentant une limite élastique σₑ donnée, réalisées chacune sur un plot de connexion; les protubérances d'interconnexion d'un composant présentant une surface S'1 de contact avec l'autre composant une fois les deux composants assemblés;
   procédé selon lequel préalablement à l'application de la force F:
- on aligne les inserts en regard des protubérances d'interconnexion ;
- on détermine d'une part la hauteur H' des protubérances d'interconnexion de sorte à ce qu'elle soit supérieure à celle h des inserts de connexion une fois les deux composants assemblés et d'autre part, la surface S'1 des protubérances de sorte que lorsqu'elles sont en contact avec l'autre composant la contrainte σ engendrée dans les protubérances d'interconnexion générée par la force F, égale à F/S'1, soit inférieure ou égale à leur limite élastique σ_{e;}
puis, on applique la force constante donnée F pour faire pénétrer les inserts dans les protubérances jusqu'à obtenir le contact entre les protubérances d'un composant avec l'autre composant en définissant la surface de contact S'1.

Cette deuxième alternative selon l'invention ne nécessite donc pas de cales à proprement parler, c'est-à-dire des protubérances distinctes de celles de connexion et qui sont rajoutées selon la première alternative pour augmenter la surface de contact entre composants lors de l'assemblage. Autrement dit, selon cette deuxième alternative, seule la déformation plastique des protubérances d'interconnexion initialement dans l'assemblage induit une augmentation de surface S'1 suffisante pour que lors de la phase finale de l'assemblage la contrainte engendrée redevienne inférieure à la limite de déformation élastique des protubérances. Dans le cas où S'1 est dimensionné de telle sorte que σ_{e =} F/S'1, la surface des protubérances est suffisante pour provoquer l'arrêt de l'insertion lors du contact entre les protubérances et l'autre composant, sans déformation plastique des protubérances.

Cette deuxième alternative est avantageusement mise en oeuvre lorsque le pas d'interconnexion entre deux plots de connexion est faible, de préférence lorsqu'il est inférieur ou égal à 20µm.

Avantageusement, selon les deux alternatives de l'invention, l'alignement et l'application de la force F sont réalisés à température ambiante.

Le matériau ductile constitutif des protubérances d'interconnexion et le cas échéant des cales est (sont) choisi(s) de préférence parmi l'indium, un alliage aluminium-cuivre, des alliages de SnAgCu, SnAg, AgCu, SnCu, Al seul, Cu seul.

Les inserts selon l'invention sont de préférence des tubes borgnes dont la base est fixée à un plot de connexion. Les inserts sont ainsi avantageusement fabriqués comme décrit dans la demande de brevet WO2009/115686 ou dans la demande EP 2287904. De manière générale, les inserts conducteurs selon l'invention peuvent présenter toute forme : micro-tube, pointe, barre ouverte, élément à section transversale en étoile, en croix, avec lobes....Une fois que la contrainte engendrée dans les protubérances d'interconnexion est inférieure ou égale à leur limite élastique σₑ, on peut maintenir la force F pendant un certain temps.

L'espacement entre les deux composants correspondant à la hauteur H ou H' est inférieur à 20µm, typiquement égale à 2 µm.

Selon un mode de réalisation avantageux, un des composants est une puce et l'autre composant est un substrat de circuit imprimé.

### Description détaillée

D'autres avantages et caractéristiques de l'invention ressortiront mieux à la lecture de la description détaillée de l'invention faite à titre illustratif et non limitatif en référence aux figures suivantes parmi lesquelles :
- la figure 1 est une vue schématique en coupe des deux composants avant leur assemblage selon la première alternative de l'invention ;
- les figures 2A à 2F illustrent les différentes étapes d'assemblage de deux composants selon la première alternative de l'invention ;
- les figures 3A à 3F illustrent les différentes courbes de contraintes engendrée dans les protubérances d'interconnexion à chaque étape d'assemblage illustrée en figures 2A à 2F;
- la figure 4 est une vue en coupe illustrant un assemblage de deux composants après leur assemblage selon la première alternative de l'invention ;
- la figure 5 est une vue en coupe illustrant un empilement de deux assemblages de deux composants après leur assemblage selon la première alternative de l'invention ;
- les figures 6A à 6C sont des vues schématiques de dessus d'un composant montrant différents agencements possibles des protubérances d'interconnexion et des cales selon la première alternative de l'invention ;
- les figures 7A et 7B sont des vues schématiques de dessus d'un composant montrant deux agencements possibles des protubérances d'interconnexion selon la deuxième alternative de l'invention.

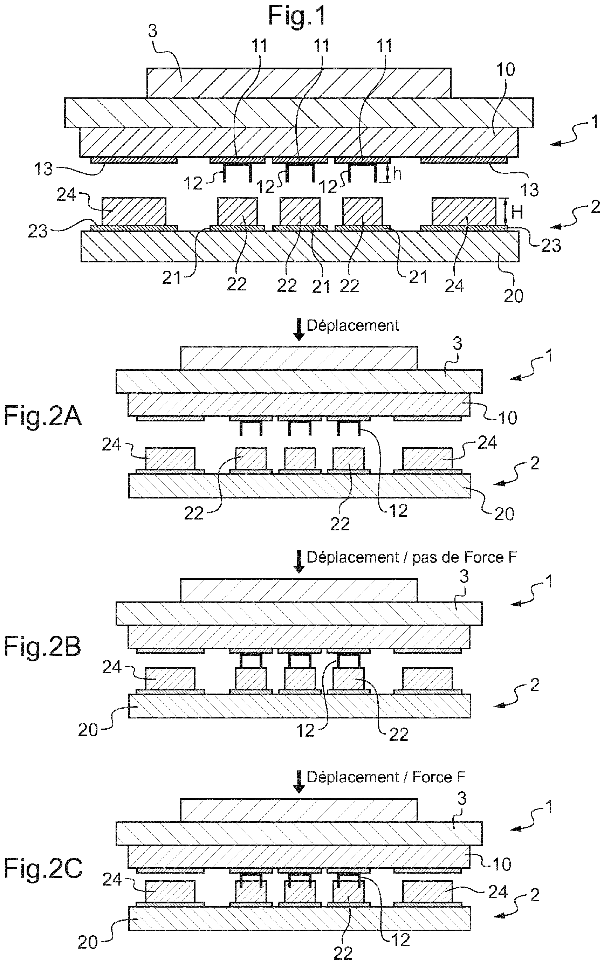

On a représenté en figure 1 deux composants électroniques 1, 2, tels que des puces électroniques à hybrider selon la première alternative de l'invention au moyen d'un outil de pressage 3 en appui sur le composant supérieur 1.

Le composant 1, qui est celui retourné, comporte un substrat 10 sur lequel des plots de connexion 11 de même hauteur ont été réalisés. Sur chacun des plots de connexion 11 est solidarisé par sa base un insert conducteur 12 sous la forme d'un tube borgne. Pour réaliser ces inserts conducteurs 12, on a procédé avantageusement comme décrit dans la demande de brevet WO2009/115686. A la périphérie des plots de connexion 11 ont été réalisés de préférence simultanément d'autres plots 13 de même hauteur que celle des plots de connexion 11.

Le composant 2 comporte quant à lui un substrat 20 sur lequel des plots de connexion 21 de même hauteur ont été réalisés. Chacun des plots de connexion 21 est surmonté d'une protubérance de connexion 22 de forme parallépipédique. A la périphérie des plots de connexion 21 ont été réalisés de préférence simultanément d'autres plots 23 de même hauteur que celle des plots de connexion 21. Les protubérances d'interconnexion 22 présentent une surface S1 de contact avec le composant 1 une fois les deux composants assemblés.

Selon la première alternative de l'invention, chacun de ces plots périphériques 23 est surmonté d'une protubérance d'espacement 24, dite cale. Les cales 24 présentent une surface S2 de contact avec le composant 1.

Selon l'invention, on détermine par calcul :
- la hauteur H de sorte qu'elle soit supérieure à celle h des inserts 12 ;
- la surface S2 des cales 24 de sorte que lorsqu'elles sont en contact avec le composant 1 comme détaillé par la suite, la contrainte σ engendrée dans les protubérances d'interconnexion 22, générée par la force F d'assemblage, égale à F/(S1+S2) soit inférieure ou égale à leur limite élastique σₑ.

Les tableaux 1 à 3 ci-après présentent trois exemples de calcul pour réaliser un assemblage selon l'invention. Le tableau 1 présente le cas de protubérances d'interconnexion 22 et cales 24 réalisées en indium pour lequel la limite élastique considérée est égale à 1MPa, le tableau 2 présente le cas de protubérances d'interconnexion 22 et cales 24 en aluminium-cuivre pour lequel la limite élastique considérée est égale à 100MPa, et enfin le tableau 3 présente le cas de protubérances d'interconnexion 22 et cales 24 en un matériau quelconque avec une limite élastique considérée à 40 MPa.

On précise ici que dans les tableaux 1 à 3 toutes les dimensions des cales 24 sont calculées en mètre et en considérant un cordon périphérique continu. Aussi, il est mentionné respectivement la largeur, la longueur et l'épaisseur du cordon, c'est-à-dire du cordon périphérique continu.

**TABLEAU 1**

| Nombre de connexions 11, 21 | | 95076 | 353508 | 1152692 |
|---|---|---|---|---|
| Hauteur H des protubérances d'interconnexion 22 (µm) | | 2,78 | 5,34 | 10,46 |
| Force F à appliquer sur composants 1, 2 (N) | | 7,5 | 30 | 120 |
| Limite de contrainte à obtenir (MPa) | | 1 | 1 | 1 |
| Surfaces de contact (m²) | Surface totale nécessaire | 7,5*10⁻⁶ | 3,00*10⁻⁵ | 1,20*10⁻⁴ |
| | Surface S1 des protubérances d'interconnexion 22 | 4,66*10⁻⁶ | 1,73*10⁻⁵ | 5,65*10⁻⁵ |
| | Surface S2 des cales 24 déterminée | 2,84*10⁻⁶ | 1,27*10⁻⁵ | 6,35*10⁻⁵ |
| Dimensions des cales 24 (m) | Largeur du cordon | 2,80*10⁻³ | 5,36*10⁻³ | 1048*10⁻³ |
| | Longueur du cordon | 3,44*10⁻³ | 6,64*10⁻³ | 11,04*10⁻³ |
| | Epaisseur du cordon | 213*10⁻⁶ | 488*10⁻⁶ | 1320*10⁻⁶ |

**TABLEAU 2**

| Nombre de connexions 11,21 | | 95076 | 353508 | 1152692 |
|---|---|---|---|---|
| Hauteur H des protubérances d'interconnexion 22 (µm) | | 2,78 | 5,34 | 10,46 |
| Force F à appliquer sur composants 1, 2 (N) | | 550 | 2200 | 8800 |
| Limite de contrainte à obtenir (MPa) | | 100 | 100 | 100 |
| Surfaces de contact (m²) | Surface totale nécessaire | 5,5*10⁻⁶ | 2,20*10⁻⁵ | 8,80*10⁻⁵ |
| | Surface S1 des protubérances d'interconnexion 22 | 4,66*10⁻⁶ | 1,73*10⁻⁵ | 5,65*10⁻⁵ |
| | Surface S2 des cales 24 déterminée | 8,41*10⁻⁷ | 4,68*10⁻⁶ | 3,15*10⁻⁵ |
| Dimensions des cales 24 (m) | Largeur du cordon | 2,80*10⁻³ | 5,36*10⁻³ | 1048*10⁻³ |
| | Longueur du cordon | 3,44*10⁻³ | 6,64*10⁻³ | 11,04*10⁻³ |
| | Epaisseur du cordon | 66*10⁻⁶ | 189*10⁻⁶ | 688*10⁻⁶ |

**TABLEAU 3**

| Nombre de connexions 11,21 | | 95076 | 353508 | 1152692 |
|---|---|---|---|---|
| Hauteur H des protubérances d'interconnexion 22 (µm) | | 2,78 | 5,34 | 10,46 |
| Force F à appliquer sur composants 1, 2 (N) | | 250 | 1000 | 4000 |
| Limite de contrainte à obtenir (MPa) | | 40 | 40 | 40 |
| Surfaces de contact (m²) | Surface totale nécessaire | 6,25*10⁻⁶ | 2,50*10⁻⁵ | 8,80*10⁻⁵ |
| | Surface S1 des protubérances d'interconnexion 22 | 4,66*10⁻⁶ | 1,73*10⁻⁵ | 1,00*10⁻⁴ |
| | Surface S2 des cales 24 déterminée | 1,59*10⁻⁶ | 7,68*10⁻⁶ | 4,35*10⁻⁵ |
| Dimensions des cales 24 (m) | Largeur du cordon | 2,80*10⁻³ | 5,36*10⁻³ | 1048*10⁻³ |
| | Longueur du cordon | 3,44*10⁻³ | 6,64*10⁻³ | 11,04*10⁻³ |
| | Epaisseur du cordon | 123*10⁻⁶ | 304*10⁻⁶ | 931*10⁻⁶ |

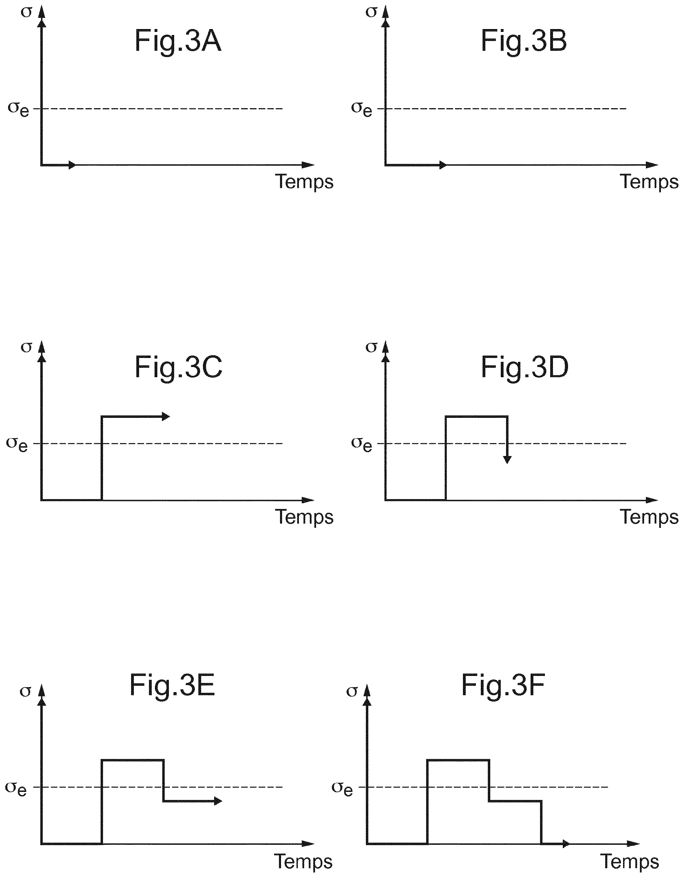

On décrit maintenant les différentes étapes d'assemblage selon la première alternative de l'invention en relation aux figures 2A à 3F. On précise que sur les figures 3A à 3F, la droite horizontale en pointillés indique la limite élastique σₑ des protubérances d'interconnexion 22.

Etape 1 : on met en approche et aligne les deux composants 1, 2 de sorte à avoir chaque insert 12 en regard d'une protubérance de connexion 22 (figure 2A). La contrainte engendrée dans les protubérances d'interconnexion 22 est nulle (figure 3A).

Etape 2 : le contact entre inserts 12 et protubérances 22 est détecté (figure 2B). La contrainte engendrée dans les plots d'interconnexion est sensiblement nulle (figure 3B).

Etape 3 : la force F est appliquée ce qui entraîne l'insertion des inserts 12 dans les protubérances 22, c'est-à-dire un chargement et la déformation plastique de ces dernières (figure 2C). La contrainte engendrée dans les protubérances d'interconnexion 22 dépasse immédiatement la limite élastique σₑ puis reste sensiblement constante (figure 3C). En effet, dès l'application de la force F, la contrainte σ engendrée dans les protubérances 22 est égale à F/Si, dans laquelle Si désigne la section transversale des inserts 12. La section Si étant très faible devant la force appliquée, la contrainte engendrée est très élevée et chaque protubérance 22 est alors déformée plastiquement. Tout au long de l'application de la force F et tant que seuls les inserts 12 sont en contact uniquement d'insertion avec les protubérances 22, la contrainte engendrée reste constante puisqu'égale pour chaque protubérance à F/Si et, dans leur régime plastique. Il y a donc insertion de chaque insert 12 par déformation plastique de chaque protubérance correspondante 22.

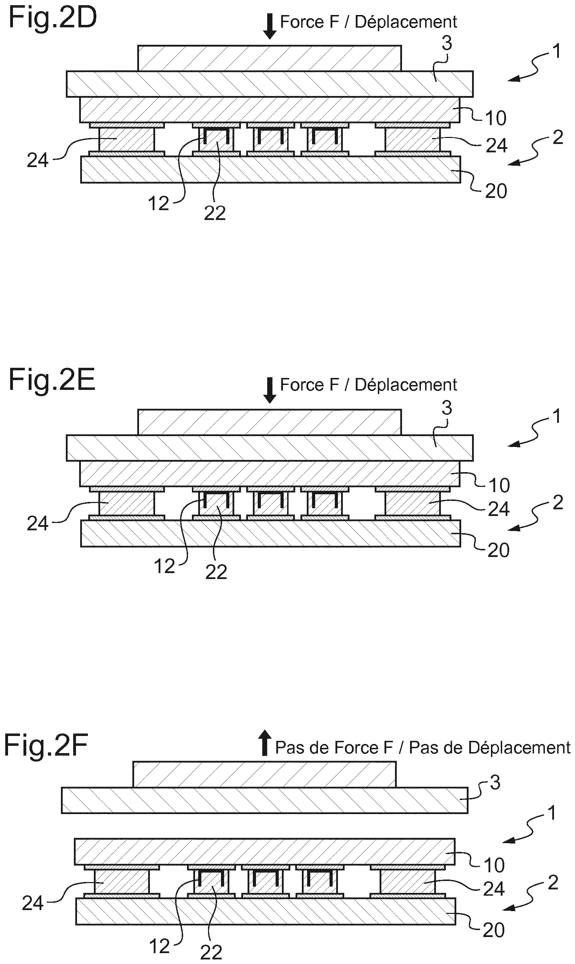

Etape 4 : la force F est appliquée jusqu'à obtenir l'insertion totale des inserts 12 dans les protubérances qui correspond exactement au contact d'assemblage des plots périphériques 13 avec les cales 24 ainsi que des plots 13 auxquels sont solidarisés les inserts 12(figure 2D). La contrainte engendrée dans les protubérances d'interconnexion 22 chute brutalement et redescend sous la limite élastique σₑ de leur matériau constitutif (figure 3D). En effet, ici, la contrainte engendrée σ dans chaque protubérance 22 devient égale à F/ (S1+S2), puisque la surface de contact lors de l'assemblage devient égale à la somme des surfaces S1 des protubérances 22 et S2 des cales 24. Autrement dit, la forte augmentation de surface de contact entre le contact d'insertion où la surface sur laquelle est appliquée la force F est celle des inserts Si et le contact d'assemblage où la surface devient égale à S1 + S2, induit la diminution de la contrainte engendrée dans chaque protubérance sous sa limite élastique σₑ. Le régime de contrainte engendrée à chaque protubérance 22 étant élastique, la déformation induite sur cette dernière est très faible conformément à la loi de Hooke lorsqu'on applique et continue à appliquer la force constante F. Typiquement, pour une protubérance 22 en aluminium cuivre d'épaisseur de l'ordre de 2 µm, on considère qu'au maximum sa déformation va être de 0,02%, c'est-à-dire une variation de hauteur égale à 0,004 µm, ce qui est négligeable. Cela signifie donc qu'une fois le contact d'assemblage atteint, on peut continuer à appliquer la force F sans risque de voir les inserts 12 continuent à s'insérer (s'enfoncer) dans les protubérances de connexion 22. Autrement dit, une fois le contact d'assemblage atteint avec le régime élastique des protubérances 22, en cas de maintien de la force d'insertion initiale F, il n'y a pas de risque de dégradation des inserts 12 par contact non souhaité avec le composant inférieur 2, typiquement un circuit imprimé. Et surtout, il n'y a pas de risque de dégradation du composant 1, typiquement une puce électronique, car les contraintes subies sont limitées.

Etape 5: on maintient encore la force F appliquée pendant un temps quelconque (figure 2 E). La contrainte engendrée dans les protubérances d'interconnexion 22 n'évolue plus car la force appliquée et la surface de contact totale entre les deux composants 1, 2 sont constantes (figure 3 E).

Etape 6: on réalise un déchargement et un retrait de l'outil de presse 3 (figure 2F). La contrainte engendrée dans les protubérances d'interconnexion 22 retombe à zéro (figure 3F). Les deux composants 1, 2 sont assemblés (hybridés) avec la connexion électrique établie entre chaque plot de connexion 11 et chaque plot de connexion 21.

On précise ici qu'on peut prévoir d'utiliser un flux, ou d'obtenir une atmosphère contrôlée lors de l'insertion. Cela peut permettre en particulier de briser l'oxyde lors des assemblages par thermocompression. Dans le cas d'inserts conducteurs sous la forme de micro-tubes, l'assemblage se fait à température ambiante et les oxydes sont brisés lorsqu'un micro-tube vient s'insérer dans la protubérance correspondante.

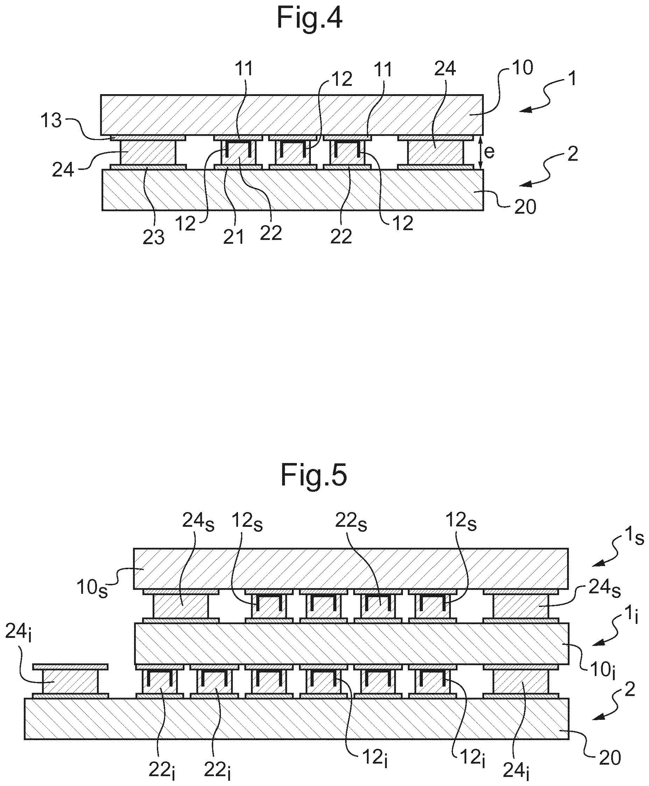

La figure 4 montre un assemblage obtenu selon le procédé d'assemblage qui vient d'être décrit.

La figure 5 montre un empilement de deux assemblages obtenus chacun selon le procédé d'assemblage qui vient d'être décrit. Lors de l'assemblage du composant supérieur 1s, l'espace entre composants inférieurs 1i, 2 reste identique du fait qu'on a déterminé au préalable les protubérances d'interconnexion 22i et cales 24i inférieures de sorte qu'elles restent dans leur domaine élastique lors de l'insertion des inserts conducteurs 12s supérieurs. A titre d'exemple et en référence au tableau 2, on peut par exemple envisager pour toutes les cales et protubérances en matériau aluminium-cuivre (Al-cu), un empilement de deux assemblages avec :
- un nombre égal à 353508 interconnexions dans l'assemblage inférieur, la force constante appliquée lors de l'insertion étant égale à 2200N ;
- un nombre égal à 95076 interconnexions dans l'assemblage supérieur, la force constante appliquée lors de l'insertion étant égale à 550N.

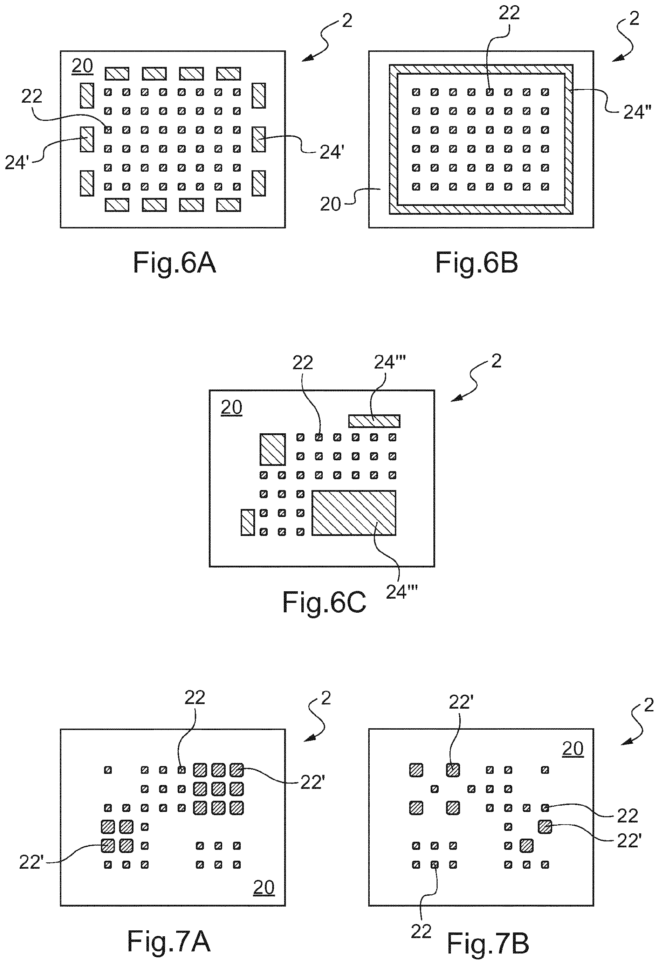

Les figures 6A à 6C montrent différents agencements relatifs des cales 24 par rapport aux protubérances d'interconnexion 22 que l'on peut envisager. Ainsi, on peut prévoir des cales 24' réparties sous forme de couronne périphérique discontinue autour des protubérances 22 (figure 6A). On peut aussi prévoir de réaliser une seule cale 24" sous la forme d'un cordon périphérique continu autour des protubérances 22 (figure 6B). On peut enfin prévoir de réaliser des cales 24''' en groupes répartis au sein des protubérances 22 (figure 6C).

Selon une autre alternative de l'invention, on peut ne pas prévoir de cales 24 : pour ce faire, on calcule la surface et la hauteur initiales des protubérances d'interconnexion 22 de sorte que ce soit uniquement leur déformation plastique qui induise le changement de surface de contact progressif et donc le passage sous leur limite élastique. Ainsi, à titre d'exemple, en reprenant les mêmes chiffres de la colonne de gauche du tableau 1, i.e. avec un nombre de connexions égal à 95076, si au final on souhaite un espacement e entre composants 1, 2 de l'ordre de 2 µm, on augmente la hauteur initiale H' des protubérances 22 jusqu'à une valeur de l'ordre de 3,2 µm.

On a représenté aux figures 7A et 7B, deux exemples de réalisation selon cette alternative. La figure 7A se distingue de la figure 7B par l'agencement relatif des protubérances d'interconnexion 22, 22' à la surface du substrat 20. Ainsi, la surface nécessaire pour obtenir le passage sous la limite élastique des protubérances d'interconnexion 22, 22' correspond exactement à la surface totale de celles-ci. Ainsi, les protubérances d'interconnexion 22, 22' vont se déformer plastiquement lors de l'insertion des inserts conducteurs jusqu'à ce que la surface totale ainsi déformée permette de revenir sous leur limite élastique. Il va de soi que si sur ces figures, les protubérances 22' sont initialement déterminées avec une section bien plus importante que les protubérances 22, on peut envisager d'avoir toutes les protubérances d'interconnexion de même section transversale unitaire.

D'autres variantes et améliorations peuvent être prévues sans pour autant sortir du cadre de l'invention.

Ainsi, dans l'ensemble des figures, les cales 24 sont réalisées sur des plots 23, à des fins de facilité de procédé de réalisation. En particulier, par rapport au procédé de réalisation décrit dans la demande de brevet EP2287904 précitée, l'ajout de plots 23 dédiés aux cales 24 permet un contrôle très précis de l'espace entre composants 1, 2 sans qu'une étape de réalisation supplémentaire soit nécessaire et sans surcoût. Cela étant, on peut très bien envisager de supprimer les plots 23 dédiés aux cales 24.

Par ailleurs, on peut envisager de réaliser l'assemblage selon l'invention entre deux circuits imprimés ou entre un composant en tant que détecteur et un autre composant en tant que circuit de lecture, un capteur et un autre capteur.

On peut aussi envisager de fabriquer les cales et les protubérances d'interconnexion chacun en un empilement de matériaux, par exemple sous forme d'un pilier de cuivre recouvert d'une couche de SnAgCu.

Une fois l'assemblage réalisé, on peut envisager de compléter le procédé par un dépôt de colle réalisé par capillarité. Dans le cas où l'un des composants (ou les deux) a été enduit, avant assemblage, de colle, on utilise avantageusement une colle de faible viscosité. On pourra alors considérer que l'influence de la présence de colle sur les composants est négligeable face aux efforts appliqués.

L'invention n'est pas limitée aux exemples qui viennent d'être décrits ; on peut notamment combiner entre elles des caractéristiques des exemples illustrés au sein de variantes non illustrées.

## Revendications

1. Procédé d'assemblage de type flip-chip, de deux composants micro électroniques (1, 2) l'un à l'autre, lesdits composants comportant chacun une face dite face d'assemblage selon lequel on rapproche les deux faces d'assemblage l'une de l'autre et on applique une force constante donnée F à l'un et/ou l'autre des composants, l'une et/ou l'autre face(s) d'assemblage comportant:
- des inserts de connexion (12) en matériau rigide;
- des protubérances d'interconnexion (22) en matériau ductile présentant une limite élastique σₑ donnée; les protubérances d'interconnexion d'un composant présentant une surface S1 de contact avec l'autre composant une fois les deux composants assemblés;
- des protubérances d'espacement, dites cales (24), les cales d'un composant présentant une surface S2 de contact avec l'autre composant une fois les deux composants assemblés,
procédé selon lequel préalablement à l'application de la force F:
- on aligne les inserts d'une face en regard des protubérances d'interconnexion de l'autre face;
- on détermine d'une part la hauteur H des cales de sorte à ce qu'elle soit supérieure à celle h des inserts de connexion une fois les deux composants assemblés et d'autre part, la surface S2 des cales de sorte que, lorsqu'elles sont en contact avec l'autre composant, la contrainte σ engendrée dans les protubérances d'interconnexion, générée par la force F, égale à F/(S1+S2) soit inférieure ou égale à leur limite élastique σ_{e;}
puis, on applique la force constante donnée F pour faire pénétrer les inserts dans les protubérances d'interconnexion jusqu'à obtenir le contact d'assemblage entre les cales d'un composant avec l'autre composant définissant les surfaces de contact S1 et S2.

2. Procédé d'assemblage selon la revendication 1, selon lequel les protubérances d'interconnexion et les cales sont réalisées dans le même matériau.

3. Procédé d'assemblage selon la revendication 1 ou 2, selon lequel le pas d'interconnexion entre deux plots de connexion d'un composant (1, 2) est inférieur ou égal à 50 µm.

4. Procédé d'assemblage selon l'une des revendications 1 à 3, selon lequel les cales sont de forme parallépipédique ou cylindrique.

5. Procédé d'assemblage selon l'une des revendications 1 à 4, selon lequel les cales sont agencées sous la forme d'une couronne périphérique discontinue (24') ou sous la forme d'un cordon périphérique continu (24").

6. Procédé d'assemblage selon l'une des revendications 1 à 4, selon lequel les cales (24"') sont réparties par groupe au sein des protubérances.

7. Procédé d'assemblage de type flip-chip de deux composants (1, 2) microélectroniques l'un à l'autre, lesdits composants comportant chacun une face dite face d'assemblage, selon lequel on rapproche les deux faces d'assemblage l'une de l'autre et on applique d'une force constante donnée F à l'un et/ou l'autre des composants, l'une et/ou l'autre face(s) d'assemblage comportant:
- des inserts (12) de connexion en matériau rigide;
- des protubérances d'interconnexion (22, 22') en matériau ductile présentant une limite élastique σₑ donnée; les protubérances d'interconnexion d'un composant présentant une surface S'1 de contact avec l'autre composant une fois les deux composants assemblés;
procédé selon lequel préalablement à l'application de la force F:
- on aligne les inserts d'une face en regard des protubérances d'interconnexion de l'autre face;
- on détermine d'une part la hauteur H' des protubérances d'interconnexion de sorte à ce qu'elle soit supérieure à celle h des inserts de connexion une fois les deux composants assemblés et d'autre part, la surface S'1 des protubérances de sorte que lorsqu'elles sont en contact avec l'autre composant la contrainte σ engendrée dans les protubérances d'interconnexion générée par la force F, égale à F/S'1, soit inférieure ou égale à leur limite élastique σ_{e;}
puis, on applique la force constante donnée F pour faire pénétrer les inserts dans les protubérances jusqu'à obtenir le contact d'assemblage entre les protubérances (22, 22') d'un composant avec l'autre composant définissant la surface de contact S'1.

8. Procédé d'assemblage selon la revendication 7, selon lequel le pas d'interconnexion entre deux plots de connexion d'un composant (1, 2) est supérieur ou égal à 20 µm.

9. Procédé d'assemblage selon l'une des revendications précédentes, selon lequel l'alignement et l'application de la force F sont réalisés à température ambiante.

10. Procédé d'assemblage selon l'une des revendications précédentes, selon lequel le matériau ductile constitutif des protubérances d'interconnexion et le cas échéant le matériau des cales sont choisis parmi l'indium, un alliage aluminium-cuivre, des alliages de SnAgCu, SnAg, AgCu, SnCu, Al seul, Cu seul.

11. Procédé d'assemblage selon l'une des revendications précédentes, selon lequel les inserts sont des micro-tubes borgnes dont la base est fixée à un plot de connexion.

12. Procédé d'assemblage selon l'une des revendications précédentes, selon lequel une fois que la contrainte engendrée dans les protubérances d'interconnexion est inférieure ou égale à leur limite élastique σ_{e,} on maintient la force F pendant un certain temps.

13. Procédé d'assemblage selon l'une des revendications précédentes, selon lequel l'espacement entre les deux composants correspondant à la hauteur H ou H' est inférieure à 20µm, typiquement égale à 2 µm.

14. Procédé d'assemblage selon l'une des revendications précédentes, selon lequel un des composants (1) est une puce et l'autre composant (2) est un substrat de circuit imprimé.

## Patentansprüche

1. Flip-Chip Verfahren zum Zusammenbau von zwei mikroelektronischen Bauteilen (1,2), welche Bauteile jeweils eine als Montagefläche bezeichnete Fläche aufweisen, wobei die beiden Montageflächen einander angenähert werden und man eine gegebene konstante Kraft F auf das eine und/oder das andere Bauteil ausübt, wobei die eine und/oder die andere Montagefläche aufweist:
- Verbindungseinsätze (12) aus steifem Material;
- Verbindungsvorsprünge (22) aus duktilem Material, die eine gegebene Elastizitätsgrenze σₑ haben, wobei die Verbindungsvorsprünge des einen Bauteils eine Kontaktfläche S1 mit dem anderen Bauteil bilden, nachdem die beiden Bauteile zusammengebaut sind;
- Distanzvorsprünge, als Keile (24) bezeichnet, wobei die Keile des einen Bauteils eine Kontaktfläche (S2) mit dem anderen Bauteil bilden, nachdem die beiden Bauteile zusammengebaut sind,
bei welchem Verfahren man vor der Ausübung der Kraft F:
- die Verbindungseinsätze der einen Fläche gegenüberliegend zu den Verbindungsvorsprüngen der anderen Fläche ausrichtet;
- einerseits die Höhe H der Keile so bestimmt, dass sie größer ist als die Höhe h der Verbindungseinsätze, nachdem die beiden Bauteile zusammengebaut sind, und andererseits die Kontaktfläche S2 der Keile so bestimmt, dass, wenn sie mit dem anderen Bauteil in Kontakt stehen, die in den Verbindungsvorsprüngen erzeugte Spannung σ, hervorgerufen durch die Kraft F, gleich F/(S1 + S2), kleiner oder gleich der Elastizitätsgrenze σₑ ist;
- man dann die gegebene konstante Kraft F ausübt, um die Verbindungseinsätze in die Verbindungsvorsprünge eintreten zu lassen, bis der Montagekontakt zwischen den Keilen des einen Bauteils mit dem anderen Bauteil hergestellt ist, das die Kontaktflächen S1 und S2 bildet.

2. Verfahren nach Anspruch 1, bei dem die Verbindungsvorsprünge und die Keile aus dem gleichen Material gebildet werden.

3. Verfahren nach Anspruch 1 oder 2, bei dem die Einstecktiefe zwischen zweiVerbindungssteckern eines Bauteils (1, 2) kleiner oder gleich 50 µm ist.

4. Verfahren nach einem der Ansprüche 1 bis 3, bei dem die Keile eine Quaderform oder eine zylindrische Form haben.

5. Verfahren nach einem der Ansprüche 1 bis 4, bei dem die Keile in der Form eines umlaufenden diskontinuierlichen Kranzes (24') oder in der Form eines durchgehenden umlaufenden Kranzes (24") angeordnet sind.

6. Verfahren nach einem der Ansprüche 1 bis 4, bei dem die Keile (24''') gruppenweise zwischen den Vorsprüngen verteilt sind.

7. Flip-Chip Verfahren zum Zusammenbau von zwei mikroelektronischen Bauteilen (1, 2), welche Bauteile jeweils eine als Montagefläche bezeichnete Fläche aufweisen, wobei die beiden Montageflächen einander angenähert werden und man eine gegebene konstante Kraft F auf das eine und/oder das andere Bauteil ausübt, wobei die eine und/oder die andere Montagefläche aufweist:
- Verbindungseinsätze (12) aus steifem Material;
- Verbindungsvorsprünge (22, 22') aus duktilem Material, die eine gegebene Elastizitätsgrenze σₑ haben, wobei die Verbindungsvorsprünge des einen Bauteils eine Kontaktfläche S'1 mit dem anderen Bauteil bilden, nachdem die beiden Bauteile zusammengebaut sind;
bei welchem Verfahren man vor der Ausübung der Kraft F:
- die Verbindungseinsätze der einen Fläche gegenüberliegend zu den Verbindungsvorsprüngen der anderen Fläche ausrichtet;
- einerseits die Höhe H' der Verbindungsvorsprünge so bestimmt, dass sie größer ist als die Höhe h der Verbindungseinsätze, nachdem die beiden Bauteile zusammengebaut sind, und andererseits die Kontaktfläche S'1 der Verbindungsvorsprünge so bestimmt, dass, wenn sie mit dem anderen Bauteil in Kontakt stehen, die in den Verbindungsvorsprüngen erzeugte Spannung σ, hervorgerufen durch die Kraft F, gleich F/S'1, kleiner oder gleich der Elastizitätsgrenze σₑ ist;
- man dann die gegebene konstante Kraft F ausübt, um die Verbindungseinsätze in die Verbindungsvorsprünge eintreten zu lassen, bis der Montagekontakt zwischen den Verbindungsvorsprüngen (22, 22') des einen Bauteils mit dem anderen Bauteil hergestellt ist, das die Kontaktfläche S'1 bildet.

8. Verfahren nach Anspruch 7, bei dem die Einstecktiefe zweier Verbindungsstecker eines Bauteils (1, 2) größer oder gleich 20 µm ist.

9. Verfahren nach einem der vorstehenden Ansprüche, bei dem das Ausrichten und das Ausüben der Kraft F bei Umgebungstemperatur erfolgen.

10. Verfahren nach einem der vorstehenden Ansprüche, bei dem das duktile Material, das die Verbindungsvorsprünge und ggf. das Material der Keile bildet, ausgewählt ist unter Indium, einer Aluminium-Kupfer-Legierung, Legierungen von SnAgCu, SnAg, AgCu, SnCu, reinem Al, reinem Cu.

11. Verfahren nach einem der vorstehenden Ansprüche, bei dem die Verbindungseinsätze Mikroröhren-Stecker sind, deren Basis an einem Verbindungssockel befestigt ist.

12. Verfahren nach einem der vorstehenden Ansprüche, bei dem man, sobald die in den Verbindungsvorsprüngen erzeugte Spannung kleiner oder gleich ihrer Elastizitätsgrenze σₑ ist, die Kraft F während einer gewissen Zeit aufrecht erhält.

13. Verfahren nach einem der vorstehenden Ansprüche, bei dem der Abstand zwischen den beiden Bauteilen, der der Höhe H oder H' entspricht, kleiner als 20 µm, typischerweise gleich 2 µm ist.

14. Verfahren nach einem der vorstehenden Ansprüche, bei dem eines der Bauteile (1) ein Chip und das andere Bauteil (2) ein Substrat einer gedruckten Schaltung ist.

## Claims

1. A flip-chip assembly process for connecting two microelectronic components (1,2) to each other, said components each comprising a face called the assembly face, in which the two assembly faces are brought together and a given constant force F is applied to one and/or the other of the components, one and/or the other assembly face(s) comprising:
- connective inserts (12) of stiff material;
- interconnect bumps (22) of ductile material having a given elastic limit σₑ, the interconnect bumps of a component having an area S1 of contact with the other component once the two components have been assembled; and
- spacer bumps, called spacers (24), the spacers of a component having an area S2 of contact with the other component once the two components have been assembled,
process in which, prior to the application of the force F:
- the inserts of one face are aligned opposite the interconnect bumps of the other face;
- on the one hand, the height H of the spacers is set so that it is greater than that h of the connective inserts once the two components have been assembled and, on the other hand, the area S2 of the spacers is set so that, when they make contact with the other component, the stress σ generated in the interconnect bumps, generated by the force F, equal to F/(S1+S2), is less than or equal to their elastic limit σₑ; and then
the given constant force F is applied in order to make the inserts penetrate into the interconnect bumps until the spacers of one component are brought into assembly contact with the other component, defining the contact areas S1 and S2.

2. The assembly process according to claim 1, wherein the interconnect bumps and the spacers are produced from the same material.

3. The assembly process according to claim 1 or claim 2, wherein the interconnect pitch between two connection pads of a component (1,2) is smaller than or equal to 50 µm.

4. The assembly process according to anyone of claims 1 to 3, wherein the spacers are of parallelepipedal or cylindrical shape.

5. The assembly process according to anyone of claims 1 to 4, wherein the spacers are arranged in the shape of a discontinuous ring (24") or in the shape of a continuous peripheral strip (24") .

6. The assembly process according to anyone of claims 1 to 4, wherein the spacers (24''') are distributed in one or more groups within the bumps.

7. A flip-chip assembly process for connecting two microelectronic components (1, 2) to each other, said components each comprising a face called the assembly face, wherein the two assembly faces are brought together and a given constant force F is applied to one and/or the other of the components, one and/or the other assembly face(s) comprising:
- connective inserts (12) of stiff material;
- interconnect bumps (22, 22') of ductile material having a given elastic limit σₑ, the interconnect bumps of a component having an area S'1 of contact with the other component once both components have been assembled;
process wherein, prior to the application of the force F:
- the inserts of one face are aligned with the interconnect bumps of the other face;
- on the one hand, the height H' of the interconnect bumps is set so that it is greater than that h of the connective inserts once the two components have been assembled and, on the other hand, the area S'1 of the bumps is set so that when they make contact with the other component the stress σ generated in the interconnect bumps, generated by the force F, equal to F/S'1, is less than or equal to their elastic limit σₑ; and then
the given constant force F is applied in order to make the inserts penetrate into the bumps until the bumps (22, 22') of a component are brought into assembly contact with the other component, defining the contact area S'1.

8. The assembly process according to claim 7, wherein the interconnect pitch between two connection pads of a component (1, 2) is larger than or equal to 20 µm.

9. The assembly process according to one of preceding claims, wherein the alignment and the application of the force F are carried out at room temperature.

10. The assembly process according to one of preceding claims, wherein the ductile material forming the interconnect bumps and, if relevant, the material of the spacers are chosen from indium, an aluminium-copper alloy, SnAgCu, SnAg, AgCu, SnCu, Al alone and Cu alone.

11. The assembly process according to one of preceding claims, wherein the inserts are blind-microtubes the bases of which tubes are fixed to connection pads.

12. The assembly process according to one of preceding claims, wherein once the stress generated in the interconnect bumps is less than or equal to their elastic limit σₑ, the force F is maintained for a certain time.

13. The assembly process according to one of preceding claims, wherein the gap between the two components, corresponding to the height H or H', is less than 20 µm and typically equal to 2 µm.

14. The assembly process according to one of preceding claims, wherein one of the components (1) is a chip and the other component (2) is a printed circuit board.
